# EUROPÄISCHE PATENTSCHRIFT

(11) **EP 0 674 805 B1**
(45) Veröffentlichungstag und Bekanntmachung des Hinweises auf die Patenterteilung: **26.03.1997**
(21) Anmeldenummer: 94901767.7
(22) Anmeldetag: 15.12.1993
(51) Int. Cl.: H01J 37/32, C23C 14/54

(54) **VERFAHREN ZUR DURCHFÜHRUNG VON STABILEN NIEDERDRUCK-GLIMMPROZESSEN**
PROCESS FOR CARRYING OUT STABLE LOW PRESSURE DISCHARGE PROCESSES
PROCEDE D'EXECUTION DE PROCEDES STABLES DE DECHARGE A BASSE PRESSION

(30) Priorität: 17.12.1992 DE 4242633
(43) Veröffentlichungstag der Anmeldung: 04.10.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: KIRCHHOFF, Volker, D-01324 Dresden (DE); RESCHKE, Jonathan, D-01067 Dresden (DE); SCHEFFEL, Bert, D-01324 Dresden (DE); GOEDICKE, Klaus, D-01307 Dresden (DE)
(86) Internationale Anmeldenummer: DE9301206
(87) Internationale Veröffentlichungsnummer: WO9414183

(56) Entgegenhaltungen:
- DD-A- 252 205
- DE-B- 1 029 213
- US-A- 3 181 029
- US-A- 5 167 748
- PATENT ABSTRACTS OF JAPAN vol. 8, no. 130 (C-229)(1567) 16. Juni 1984 & JP,A,59 041 475 (NIPPON SHINKU GIJUTSU KK) 7. März 1984
- PATENT ABSTRACTS OF JAPAN vol. 005, no. 016 (C-041)30. Januar 1981 & JP,A,55 145 170 (TOKUDA SEISAKUSHO LTD) 12. November 1980

## Beschreibung

Die Erfingung betrifft ein Verfahren zur Stabilisierung der Entladung bei Niederdruck-Glimmprozessen, insbesondere zur Vermeidung von Bogenentladungen und damit verbundenen Störungen des Gesamtprozesses, insbesondere bei Verwendung von Reaktivgasen. Das Verfahren findet Anwendung auf dem Gebiet der Plasmabehandlung von Oberflächen, der Abscheidung von Schichten aus dem Plasma und der plasmagestützten Oberflächenreinigung. Derartige Prozesse dienen vorzugsweise zur Oberflächenveredlung von Bauteilen, Werkzeugen, Halbzeugen und Fertigteilen in der Optik, im Maschinenbau, in der Verpackungs- und Glasindustrie und Elektroindustrie.

Es sind eine Vielzahl von Verfahren und Einrichtungen für die Plasmadiffusion, die plasmagestützte chemische Dampfphasenabscheidung (PECVD) und die plasmagestützte physikalische Dampfabscheidung (PVD), die Plasmapolymerisation und das Plasmaätzen bekannt. Bei all diesen Prozessen werden Elektroden eingesetzt, zwischen denen eine Glimmentladung gezündet wird. Die Energie wird dabei in Form von Gleichspannung (DC, Dc gepulst) oder Wechselspannung (AC, HF) dem Niederdruckprozeß zugeführt. Sowohl beim Einsatz von DC- als auch gepulsten DC-Stromversorgungen zur Speisung des Plasmas tritt prozeßbedingt das Umschlagen der Glimmentladung in eine Bogenentladung auf. Solche Bogenentladungen führen zu Instabilitäten bei der gesamten Prozeßführung wie auch zu lokalen Zerstörungen an den betreffenden Oberflächen der Elektroden und Substrate.

Es ist bekannt, zur Reduzierung der Schädigung der betreffenden Oberflächen durch die Bogenentladungen verschiedene Verfahren und Einrichtungen einzusetzen. Eine dazu in der Plasmatechnik weit verbreitete Lösung ist die automatische Überwachung der Bogenentladung durch die Kontrolle der elektrischen Entladungsparameter Werden Abweichungen der Parameter einer Niederdruckglimmentladung durch die Ausbildung einer Bogenentladung erkannt, erfolgt eine Abschaltung der Energiezufuhr. Nach einer Mindestzeit, die zur Löschung des Bogens notwendig ist, wird die Energie erneut zugeschaltet (DD 122 160 A 1; US-A 3,181,029).
Eine weitere Lösung zur Reduzierung der Schäden durch ungewollte Bogenentladungen und zur Erhöhung der Prozeßstabilität besteht darin, die Energie mit periodisch wiederholten Gleichstromimpulsen zuzuführen (DE 37 00 633 C 1). Damit wird jedoch die Bogenausbildung nicht verhindert, sondern nur der Energieeintrag in den Bogen auf eine Periode begrenzt. Besonders bei großen Entladungsleistungen ist der Energieinhalt innerhalb einer Periode noch so groß, daß es unweigerlich im Falle einer Bogenentladung zu Instabilitäten des Gesamtprozesses und zu Oberflächenschädigungen kommt. Deshalb ist es auch für diese Lösung mit gepulster Energiezufuhr unumgänglich, automatisch die Bogenentladung mit den oben genannten Mitteln oder mittels einer speziellen Lichtbogensensorschaltung zu erkennen und die Energiezufuhr zu unterbrechen.

Es ist darüber hinaus bekannt, z. B. für das Zerstäuben nach dem Magnetron-Prinzip über einem Magnetsystem mindestens zwei Elektroden anzuordnen, die aus dem zu zerstäubenden Material bestehen. Diese Elektroden werden so geschaltet, daß sie wechselweise Katode und Anode der Niederdruckentladung sind, oder sie werden an eine Wechselspannung angeschlossen (DD 252 205 A 1). Auch diese Lösung verhindert nicht prinzipiell das Umschlagen der Glimmentladung in eine Bogenentladung, sondern der Energieeintrag in den Bogen wird auf eine periode begrenzt.

Mit all diesen Lösungen wird nur ein sich ausbildender bzw. schon vorhandener Bogen detektiert, d. h. der Bogen wird nicht vermieden, sondern es wird versucht, die entstehenden schädlichen Auswirkungen zu minimieren. Die Energie, die im Plasma gespeichert ist, wird grundsätzlich beim Übergang von der Glimm- in die Bogenentladung über den Bogen auf die Elektroden oder Substrate abgeführt. Für die Minimierung der Zeit zwischen Bogenausbildung und dessen Erkennung und für die Reaktionszeit bis zur Fortschaltung der Energie gibt es physikalische Grenzen, die nicht unterschritten werden können.

Der weiterhin bekannte Einsatz von HF-Generatoren umgeht die obengenannten Probleme des Umschlagens der Glimmentladung in eine Bogenentladung vom Prinzip her, aber er hat den Nachteil der hohen Kosten, des hohen apparativen Aufwandes und des Problems der Impedanzanpassung zwischen dem Prozeß und dem HF-Generator. Daher ist diese Art der Energiezufuhr auf spezielle Anwendungsgebiete beschränkt.

Es ist weiterhin bekannt, das Plasma bei der Niederdruck-Glimmentladung mittels Analyse der optischen Emission zu detektieren und damit bei der reaktiven Beschichtung die Steuerung der Schichtzusammensetzung vorzunehmen (U.S.Patent 4,166,784; U.S.Patent 4,407,709). Dabei wird die Intensität der optischen Emission des Plasmas als StellgrÖße für den Reaktivgasfluß bzw. für die Stromversorgung genutzt. Diese Verfahren bewirken eine Stabilisierung der reaktiven Prozeßführung beim Abscheiden von Schichten mit definierter Schichtzusammensetzung. Auch diese Verfahren schaffen keine Möglichkeit, die Ausbildung von Bogenentladungen zu erkennen und darauf zu reagieren, sondern benötigen zusätzlich eine oben beschriebene Bogenfortschaltung mit den genannten Nachteilen. Doch gerade bei diesen Prozessen ist die Neigung zum Umschlagen in eine Bogenentladung besonders stark, bedingt durch die Unterschiede in der elektrischen Leitfähigkeit zwischen dem zu zerstäubenden Material und der abgeschiedenen Schicht.

Der Erfindung liegt die Aufgabe zugrunde, ein Verfahren zur Durchführung von stabilen Niederdruck-Glimmentladungen zu schaffen, das die Entstehung von Bögen bereits im Vorfeld verhindert und den Glimmprozeß über lange Zeit stabil hält. Der Aufwand soll relativ gering sein. Das Verfahren soll für alle Glimmprozesse wie das plasmagestützte Beschichten und die Plasmabehandlung von Oberflächen, insbesondere die plasmagestützte Oberflächenreinigung, anwendbar sein.

Erfindungsgemäß wird die Aufgabe nach den Merkmalen des Anspruches 1 gelöst. Vorteilhafte Ausgestaltungen des Verfahrens sind in den Ansprüchen 2 bis 14 beschrieben.

Ein besonderer Vorteil des erfindungsgemäßen Verfahrens besteht darin, daß durch die Detektierung des Plasmazustandes der Zeitpunkt vor dem Übergang der Glimmentladung in eine Bogenentladung bzw. vor dem Auftreten von Instabilitäten der Glimmentladung erkannt wird. Eine physikalische Ursache für die Instabilitäten können lokale Aufladungen von isolierten Bereichen innerhalb des Plasmaraumes sein. Beim Überschreiten einer bestimmten Ladungsdichte in diesen Bereichen kommt es ohne das erfindungsgemäße Verfahren zu einem elektrischen Durchbruch, der Ausgangspunkt einer Bogenentladung wäre. Durch die erfindungsgemäße Lösung wird eine Regenerierungsphase eingeleitet, die die Ursachen für das Entstehen eines Bogens beseitigt.

Maßgebend für die Einleitung einer Regenerierungsphase ist die Hohe des Aufladungspotentials. Dieses wird von der Energie, die in das Plasma eingebracht wird, der Charakteristik der Isolation und der örtlichen Plasmadichte bestimmt. Überraschenderweise kann durch die Überwachung einer oder mehrerer dieser Parameter eine charakteristische Größe gewonnen werden, die diesen Zustand erkennen läßt und die Möglichkeit gibt, vorausschauend in den Niederdruck-Glimmprozeß einzugreifen. Die Bestimmung dieser Parameter ist auch unter Bedingungen einer stabilen Niederdruckglimmentladung möglich. Es wird nicht erst der Übergang von der Glimm- zur Bogenentladung abgewartet und aus der Analyse der Strom-Spannungskennlinie der kritische instabile Entladungszustand detektiert, wie das bei herkömmlichen Verfahren geschieht. Dieser Umschlag von der Glimm- in die Bogenentladung tritt bei dem erfindungsgemäßen Verfahren nicht mehr auf.
Wird die eingebrachte Energie in das Plasma zur Charakterisierung des Plasmas verwendet, ist es günstig, die elektrischen Entladungsparameter durch Intergration über der Zeit zu bestimmen.

Eine bekannte Methode, die örtliche Plasmadichte zu überwachen, beruht auf der Analyse der optischen Emission des Plasmas und kann auch für dieses erfindungsgemäße Verfahren effektiv eingesetzt werden.

Überraschenderweise hat sich weiterhin gezeigt, daß es Möglichkeiten gibt, den Plasmaraum schnell zu regenerieren und dadurch den Ausgangszustand für die Ausbildung eines stabilen Glimmplasmas wiederherzustellen, d. h. den Glimmprozeß wieder zu starten. Eine Variante der Regenerierung besteht darin, die Energiezufuhr in das Plasma für die Zeit zu unterbrechen, in der eine Selbstentladung der isolierten Bereiche erfolgt, und danach den Glimmprozeß erneut zu starten. Eine andere Möglichkeit zur Herstellung des Ausgangszustandes besteht darin, für die Zeit der Regenerierungsphase einen zusätzlichen Verbraucher mit der Gleichstromversorgung zu verbinden und darüber die Regenerierung zu bewirken. Als zweiter Verbraucher kann auch eine elektrisch leitende Verbindung zwischen den Glimmelektroden verwendet werden.
Eine weitere vorteilhafte Ausgestaltung des Verfahrens besteht darin, daß die Regenerierungsphase durch Vertauschen der Polarität an den Glimmelektroden bewirkt wird und damit über ein entgegengesetzt polarisiertes Plasma eine Regenerierung erfolgt. Diese Verfahrensweise ist besonders für Zerstäubungsverfahren mit zwei abstäubbaren Elektroden geeignet, die wechselweise als Kathode und Anode geschaltet werden.
Die Effektivität der in den Unteransprüchen beschriebenen Ausgestaltungen des Verfahrens ist abhängig von dem speziellen Niederdruck-Glimmprozeß und dem Anwendungsfall, wobei an sich bekannte Mittel hierfür eingesetzt werden können.
Es hat sich gezeigt, daß für diese Formen der Regenerierung Zeiten von mindestens 1 µs notwendig sind.

An zwei Ausführungsbeispielen wird die Erfindung näher erläutert. In der zugehörigen Zeichnung zeigen:
Fig. 1: eine Einrichtung zur Substratreinigung mittels Plasmaätzprozeß,
Fig. 2: eine Einrichtung zum reaktiven Zerstäuben.

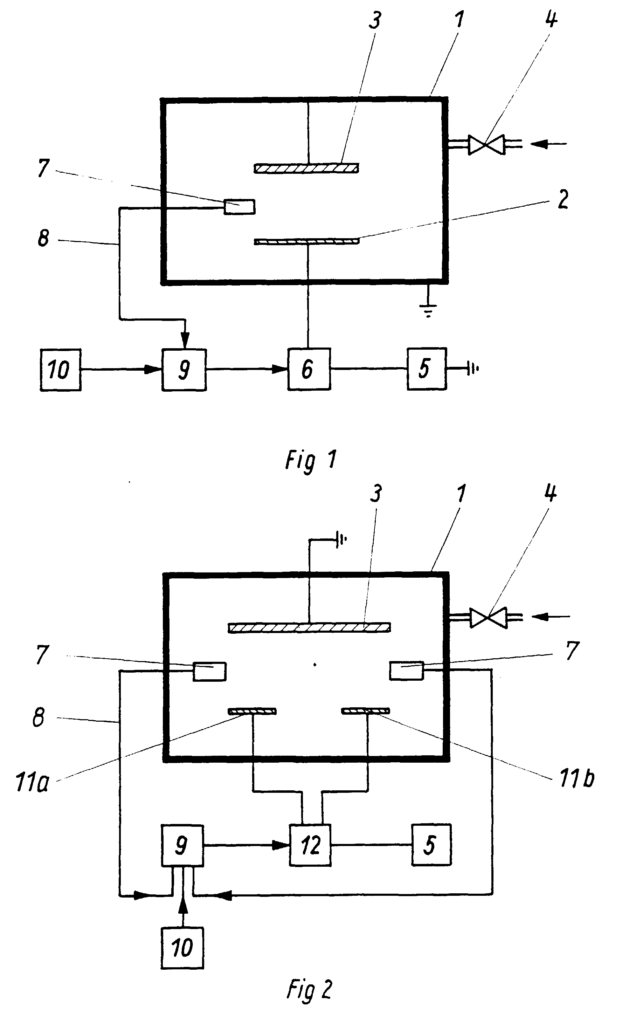

Gemäß Fig. 1 befindet sich in einer Vakuumkammer 1 die Elektrode 2 der Plasmaätzanordnung. Oberhalb der Elektrode 2 befindet sich ein Substrat 3 auf Massepotential. An der Vakuumkammer 1 ist ein Gaseinlaßventil 4 zur Zuführung von Argon als Prozeßgas angeordnet. Die Plasmaätzanordnung wird von einer DC-Stromversorgung 5 über eine Schalteinheit 6 gespeist. Mittels eines optischen Sensors 7 zur Bestimmung der Intensität einer Emissionslinie wird der Plasmazustand in-situ gemessen und über eine Lichtleitfaser 8 einer an sich bekannten Elektronikeinheit 9 zugeführt. Zusätzlich wird in die Elektronikeinheit 9 ein experimentell ermittelter Vergleichswert über die Referenzeingabe 10 eingegeben. Die DC-Stromversorgung 5 arbeitet im Konstant-Leistungsbetrieb bei einer elektrischen Leistung von 2 kW und einer Spannung von ca. 3,6 kV. Der Totaldruck in der Vakuumkammer 1 beträgt 2,4 Pa. In der Elektronikeinheit 9 wird die Intensität der Argonlinie bei 420 nm in ein äquivalentes elektrisches Spannungssignal im Bereich zwischen 0 und 10 V umgewandelt und über die Zeit integriert. Durch den Vergleich mit dem Sollwert an der Referenzeingabe 10 wird der Zeitpunkt ermittelt, nach dem mittels der Schalteinheit der Regenerierungsprozeß gestartet wird. Für diese Anordnung wurde der Vergleichswert von 0,2 mVs ermittelt, mit dem ein stabiler bogenfreier Plasmaätzprozeß über 5 Stunden störungsfrei arbeitete.
In den Regenerierungsphasen wurde hierbei die Plasmaätzeinrichtung über eine Dauer von 30 µs mit Massepotential verbunden. Die Länge der Ätzphasen ändern sich dabei von anfänglich 20 µs auf ca. 50 µs gegen Ende der Bearbeitungszeit.

In Fig. 2 ist eine Einrichtung dargestellt, mit deren Hilfe eine Beschichtung mittels stabilisiertem Glimmprozeß für das reaktive Zerstäuben unter Verwendung einer bekannten Zerstäubungseinrichtung für Aluminiumoxid erfolgt.
In einer Vakuumkammer 1 befindet sich die Zerstäubungseinrichtung, bestehend aus den zwei Elektroden 11a; 11b aus Aluminium. Oberhalb der Zerstäubungseinrichtung befindet sich in einem Abstand von 100 mm das Substrat 3, welches auf Massepotential gelegt ist. An der Vakuumkammer 1 befindet sich ein Gaseinlaßventil 4 zur Zuführung eines Argon/Sauerstoff-Gemisches mit einem Mischungsverhältnis von 50/50 bei konstantem Fluß. Die Zerstäubungseinrichtung wird von einer DC-Stromversorgung 5 über eine Schalteinheit 12 gespeist. Mittels der optischen Sensoren 7 wird der Plasmazustand in-situ in einem Abstand von 5 mm von den zugehörigen Elektroden 11a; 11 b gemessen und über eime Lichtleitfaser 8 einer an sich bekannten Elektronikeinheit 9 zugeführt. Zusätzlich erhält die Elektronikeinheit 9 einen experimentell ermittelten Vergleichswert von der Referenzeingabe 10. Die DC-Stromversorgung 5 arbeitet im Konstant-Leistungsbetrieb bei einer elektrischen Leistung von 12 kW und einer Spannung von ca. 600 V. Der Totaldruck in der Vakuumkammer 1 beträgt 0.4 Pa. In der Elektronikeinheit 9 wird die Intensität der Aluminiumlinie bei 396 nm in ein äquivalentes elektrisches Spannungssignal im Bereich zwischen 0 und 10 V umgewandelt, über die Zeit integriert und daraus der Meßwert gebildet. Durch den Vergleich des Meßwertes für die Elektrode 11a mit dem Wert aus der Referenzeingabe wird der Zeitpunkt ermittelt, nach dem die Elektrode 11a von Kathodenpotential auf Anodenpotential bzw. die Elektrode 11 b von Anodenpotential auf Kathodenpotential umgeschaltet wird. Arbeitet die Elektrode 11a als Anode, werden die Potentialflächen des Plasmaraumes und die Elektrode selbst mit zusätzlicher Unterstützung des umgepolten Plasmas regeneriert. Durch den Vergleich des Meßwertes des Sensors 7 an der Elektrodellb mit dem Wert aus der Referenzeingabe wird der Zeitpunkt ermittelt, nach dem die Elektrode 11b von Kathodenpotential auf Anodenpotential bzw. die Aluminiumelektrode 11a von Anodenpotential auf Kathodenpotential umgeschaltet werden. Dabei läuft die Regenerierung des Plasmaraumes der Elektrodenumgebung der Elektrode 11b analog ab. Mit dieser Prozeßführung wird parallel zur Regenerierung einer Elektrodenumgebung mittels einer zweiten Elektrode ein Plasma erzeugt, so daß praktisch keine Unterbrechung des Beschichtungsprozesses auftritt. Für diese Anordnung wurde der Vergleichswert von 0,18 mVs ermittelt, mit dem ein stabiler bogenfreier Beschichtungsprozeß auch nach 72 Stunden noch störungsfrei arbeitete. Die Länge der Regenerierungsphase für die Elektrode 11a änderte sich dabei von anfänglich 30 µs auf 25 µs nach einer Beschichtungszeit von 72 Stunden und die der Elektrode 11b im selben Zeitraum von 28 µs auf 26 µs.
Die sich bei dem Verfahren durch die Prozeßführung ergebenden unterschiedlichen Beschichtungszeiten mit den Elektroden 11a; 11b, die zu Inhomogenitäten der auf dem Substrat 3 aufgebrachten Schichten führen würden, werden dadurch ausgeschlossen, daß entweder das Substrat 3 einer Relativbewegung unterliegt oder die beiden Elektroden 11a; 11b im Verhältnis zum Substrat 3 so angeordnet sind, daß sich jeweils eine Dampfwolke bildet, die sich über das gesamte Substrat 3 ausbreitet.

## Patentansprüche

1. Verfahren zur Durchführung eines stabilen Niederdruck-Glimmprozesses im Vakuum, der durch eine Gleichstormversorgung gespeist wird, bei dem durch Unterbrechung bzw. Änderung der Energieeinspeisung in die Entladung der Glimmprozeß durch eine Regenerierungsphase unterbrochen wird und in dem die Messung des Plasmazustandes möglich ist, zur plasmagestützten Beschichtung oder Oberflächenbehandlung eines Substrates, bei dem der Zeitpunkt für den Beginn und/oder das Ende der Regenerierungsphase aus einem Vergleich eines in-situ gemessenen Wertes mit einem experimentell ermittelten Sollwert einer Größe, die den Plasmazustand charakterisiert, bestimmt wird, **dadurch gekennzeichnet** daß die Zeit für die Regenerierungsphase größer oder gleich 1 µs gewählt wird und daß der Wechsel von der Glimmphase zur Regenerierungsphase und umgekehrt während der Ausübung des Verfahrens ständig wiederholt wird.

2. Verfahren nach Anspruch 1, **dadurch gekennzeichnet,** daß der Glimmprozeß mit zwei Elektroden und mindestens einem Substrat ausgeführt wird, und an beiden Elektroden die Glimmphase und die Regenerierungsphase wechselweise durchgeführt werden.

3. Verfahren nach Anspruch 1, **dadurch gekennzeichnet,** daß die Änderung der Energieeinspeisung für die Glimmentladung durch das Anlegen eines entgegengesetzten Potentials bis zum Ende der Regenerierungsphase bewirkt wird.

4. Verfahren nach Anspruch 1, **dadurch gekennzeichnet,** daß gleichzeitig mit Unterbrechung der Energieeinspeisung für die Glimmentladung bis zum Ende der Regenerierungsphase Massepotential an die Glimmeinrichtung gelegt wird.

5. Verfahren nach Anspruch 1, **dadurch gekennzeichnet,** daß gleichzeitig mit Unterbrechung der Energieeinspeisung bis zum Ende der Regenerierungsphase die Gleichstromversorgung von der Glimmeinrichtung getrennt wird.

6. Verfahren nach Anspruch 1, **dadurch gekennzeichnet**, daß die Änderung der Energieeinspeisung für die Glimmentladung bis zum Ende der Regenerierungsphase durch Verbindung der Gleichstromversorgung mit einem zweiten Verbraucher bewirkt wird.

7. Verfahren nach Anspruch 1 und 6, **dadurch gekennzeichnet,** daß der zweite Verbraucher durch eine elektrische Verbindung zwischen den Glimmelektroden gebildet wird.

8. Verfahren nach Anspruch 1 und mindestens einem der Ansprüche 2 bis 7, **dadurch gekennzeichnet,** daß der Plasmazustand durch optische Spektroskopie ermittelt wird.

9. Verfahren nach Anspruch 8, **dadurch gekennzeichnet,** daß der Plasmazustand durch optische Emissionsmessung ermittelt wird.

10. Verfahren nach Anspruch 1 und mindestens einem der Ansprüche 2 bis 7, **dadurch gekennzeichnet,** daß der Plasmazustand durch die Produktbildung zwischen Glimmspannung, Glimmstrom und Glimmzeit ermittelt wird.

11. Verfahren nach Anspruch 1 und mindestens einem der Ansprüche 2 bis 7, **dadurch gekennzeichnet**, daß zur Charakterisierung des Plasmazustandes das Produkt aus der Glimmspannung und der Glimmzeit gebildet wird.

12. Verfahren nach Anspruch 1 und mindestens einem der Ansprüche 2 bis 7, **dadurch gekennzeichnet**, daß zur Charakterisierung des Plasmazustandes das Produkt aus dem Glimmstrom und der Glimmzeit gebildet wird.

13. Verfahren nach Anspruch 1 und mindestens einem der Ansprüche 2 bis 7, **dadurch gekennzeichnet,** daß der Plasmazustand mittels Sonden gemessen wird.

14. Verfahren nach Anspruch 1 und mindestens einem der Ansprüche 2 bis 7, **dadurch gekennzeichnet,** daß zur Ermittlung des Plasmazustandes die Temperatur im Plasma gemessen wird.

## Claims

1. Method for performing a stable low pressure glow process *in vacuo,* which is supplied by a direct current supply, in which, by interrupting or modifying the energy supply to the discharge, the glow process is interrupted by a regeneration phase, and in which measurement of the plasma state is possible, for plasma-assisted coating or surface treatment of a substrate, in which the time for the start and/or the end of the regeneration phase is determined from a comparison of a value measured *in situ* with an experimentally determined desired value of a magnitude characterising the plasma state, characterised in that the time for the regenerating phase is chosen longer than or equal to 1 µs, and in that the change from the glow phase to the regenerating phase and vice versa is constantly repeated during the performance of the method.

2. Method according to claim 1, characterised in that the glow process is performed with two electrodes and at least one substrate, and on both electrodes the glow phase and the regenerating phase are performed alternately.

3. Method according to claim 1, characterised in that the change to the energy supply for the glow discharge is brought about by applying an opposite potential up to the end of the regenerating phase.

4. Method according to claim 1, characterised in that simultaneously with the interruption of the energy supply for the glow discharge, earth potential is applied to the glow device up to the end of the regenerating phase.

5. Method according to claim 1, characterised in that simultaneously with the interruption of the energy supply and up to the end of the regenerating phase, the direct current supply is isolated from the glow device.

6. Method according to claim 1, characterised in that the change to the energy supply for the glow discharge and up to the end of the regenerating phase is brought about by connecting the direct current supply to a second load.

7. Method according to claim 1 and 6, characterised in that the second load is formed by an electrical connection between the glow-discharge electrodes.

8. Method according to claim 1 and at least one of claims 2 to 7,
characterised in that the plasma state is determined by optical spectroscopy.

9. Method according to claim 8, characterised in that the plasma state is determined by optical emission measurement.

10. Method according to claim 1 and at least one of claims 2 to 7, characterised in that the plasma state is determined by product formation between glow voltage, glow current and glow time.

11. Method according to claim 1 and at least one of claims 2 to 7, characterised in that for characterizing the plasma state the product of the glow voltage and the glow time is formed.

12. Method according to claim 1 and at least one of claims 2 to 7, characterised in that for characterising the plasma state the product of the glow current and the glow time is formed.

13. Method according to claim 1 and at least one of claims 2 to 7, characterised in that the plasma state is measured by means of probes.

14. Method according to claim 1 and at least one of claims 2 to 7, characterised in that the temperature in the plasma is measured for determining the plasma state.

## Revendications

1. Procédé de réalisation de processus stables de décharge lumineuse à basse pression sous vide, qui est alimenté par une source de courant continu, dans lequel par suite d'interruption ou de modification de l'amenée d'énergie dans la décharge le processus est interrompu par une phase de régénération et dans lequel la mesure de l'état du plasma est possible, pour l'enduction basée sur le plasma ou le traitement superficiel d'un substrat, dans lequel le moment du début et/ou de la fin de la phase de régénération est déterminé à partir d'une comparaison d'une valeur mesurée in situe avec une valeur de consigne déterminée expérimentalement d'une grandeur, qui caractérise l'état du plasma,
caractérisé en ce que
le temps de la phase de régénération est choisi plus grand ou égal à 1 µs et en ce que le changement de la phase de décharge lumineuse à la phase de régénération et inversement est répétée constamment pendant l'exercice du procédé.

2. Procédé selon la revendication 1,
caractérisé en ce que
le procédé de décharge lumineuse est réalisé avec deux électrodes et au moins un substrat et sur les deux électrodes la phase de décharge lumineuse et la phase de régénération sont réalisées alternativement.

3. Procédé selon la revendication 1,
caractérisé en ce que
la modification de l'alimentation en énergie pour la décharge lumineuse est occasionnée par l'application d'un potentiel opposé jusqu'à la fin de la phase de régénération.

4. Procédé selon la revendication 1,
caractérisé en ce qu'
en même temps que l'interruption de l'alimentation en énergie pour la décharge lumineuse jusqu'à la fin de la phase de régénération le potentiel de la masse est appliqué au dispositif de décharge.

5. Procédé selon la revendication 1,
caractérisé en ce qu'
en même temps que l'interruption de l'alimentation en énergie jusqu'à la fin de la phase de la régénération, l'alimentation en courant continu est séparée du dispositif de décharge lumineuse.

6. Procédé selon la revendication 1,
caractérisé en ce que
la modification de l'alimentation en énergie pour la décharge lumineuse jusqu'à la fin de la phase de régénération est occasionnée par la jonction de l'alimentation en continu avec un deuxième consommateur.

7. Procédé selon les revendications 1 à 6,
caractérisé en ce que
le deuxième consommateur est constitué par une liaison électrique entre les électrodes de décharge.

8. Procédé selon la revendication 1 et au moins une des revendications 2 à 7,
caractérisé en ce que
l'état du plasma est déterminé par spectroscope optique.

9. Procédé selon la revendication 8,
caractérisé en ce que
l'état du plasma est déterminé par une mesure d'émission optique.

10. Procédé selon la revendication 1 et au moins une des revendications 2 à 7,
caractérisé en ce que
l'état du plasma est déterminé par la formation du produit entre tension de décharge, intensité de décharge et temps de décharge.

11. Procédé selon la revendication 1 et au moins une des revendications 2 à 7,
caractérisé en ce que
pour caractériser l'état du plasma on forme le produit de la tension de décharge et du temps de décharge.

12. Procédé selon la revendication 1 et au moins une des revendications 2 à 7,
caractérisé en ce que
pour caractériser l'état du plasma on forme le produit de l'intensité de décharge et du temps de décharge.

13. Procédé selon la revendication 1 et au moins une des revendications 2 à 7,
caractérisé en ce que
l'état du plasma est mesuré au moyen de sondes.

14. Procédé selon la revendication 1 et au moins une des revendications 2 à 7,
caractérisé en ce que
pour la détermination de l'état du plasma, la température est mesurée dans le plasma.
